# EUROPÄISCHE PATENTSCHRIFT

(11) **EP 2 742 584 B1**
(45) Veröffentlichungstag und Bekanntmachung des Hinweises auf die Patenterteilung: **06.03.2019**
(21) Anmeldenummer: 11766957.2
(22) Anmeldetag: 29.09.2011
(51) Int. Cl.: H02M 1/32, H03K 17/082, H02H 7/122, H01L 23/62, H02M 7/483

(54) **LEISTUNGSHALBLEITERSCHALTER IN MODULBAUWEISE MIT STROMSYMMETRIEÜBERWACHUNG ZUR FEHLERERFASSUNG**
POWER SEMICONDUCTOR SWITCH MODULE WITH CURRENT SYMMETRY MONITORING FOR FAILURE DETECTION
MODULE COMMUTATEUR SEMI-CONDUCTEUR DE PUISSANCE AVEC SUPERVISION DE LA SYMÉTRIE DES COURANTS POUR DÉTECTION DE PANNE

(43) Veröffentlichungstag der Anmeldung: 18.06.2014
(73) Patentinhaber: Siemens Aktiengesellschaft, 80333 München (DE); Infineon Technologies Bipolar GmbH & Co. KG, 59581 Warstein (DE)
(72) Erfinder: DORN, Jörg, 96155 Buttenheim (DE); HUANG,Hartmut, 91056 Erlangen (DE)
(86) Internationale Anmeldenummer: PCT/EP2011/067015
(87) Internationale Veröffentlichungsnummer: WO 2013/044965

(56) Entgegenhaltungen:
- US-A1- 2006 027 917
- US-A1- 2011 103 108
- PALMER P R ET AL: "Noninvasive measurement of chip currents in IGBT modules", POWER ELECTRONICS SPECIALISTS CONFERENCE, 1997. PESC '97 RECORD., 28TH ANNUAL IEEE ST. LOUIS, MO, USA 22-27 JUNE 1997, NEW YORK, NY, USA,IEEE, US, Bd. 1, 22. Juni 1997 (1997-06-22), Seiten 166-171, XP010241544, DOI: 10.1109/PESC.1997.616722 ISBN: 978-0-7803-3840-1
- DALESSANDRO L ET AL: "Online and offline isolated current monitoring of parallel switched high-voltage multi-chip IGBT modules", POWER ELECTRONICS SPECIALISTS CONFERENCE, 2008. PESC 2008. IEEE, IEEE, PISCATAWAY, NJ, USA, 15. Juni 2008 (2008-06-15), Seiten 2600-2606, XP031300356, ISBN: 978-1-4244-1667-7
- CHUCHENG XIAO ET AL: "An overview of integratable current sensor technologies", CONFERENCE RECORD OF THE 2003 IEEE INDUSTRY APPLICATIONS CONFERENCE. 38TH. IAS ANNUAL MEETING . SALT LAKE CITY, UT, OCT. 12 - 16, 2003; [CONFERENCE RECORD OF THE IEEE INDUSTRY APPLICATIONS CONFERENCE. IAS ANNUAL MEETING], NEW YORK, NY : IEEE, US, Bd. 2, 12. Oktober 2003 (2003-10-12), Seiten 1251-1258, XP010675997, DOI: 10.1109/IAS.2003.1257710 ISBN: 978-0-7803-7883-4
- Yanick Lobsiger ET AL: "Voltage, Current and Temperature Measurement Concepts Enabling Intelligent Gate Drives", ECPE Workshop Munich, 30. Juni 2011 (2011-06-30), XP55037656, Gefunden im Internet: URL:http://www.pes.ee.ethz.ch/uploads/tx_e thpublications/Lobsiger_Measurement_Concep ts_ECPE_WS_2011.pdf [gefunden am 2012-09-10]
- A Nonymous: "Sense & Control Application Note Current Sensing Using Linear Hall Sensors", , 3 February 2009 (2009-02-03), pages 1-18, XP055311785, Retrieved from the Internet: URL:http://www.infineon.com/dgdl/Current_S ensing_Rev.1.1.pdf?fileId=db3a304332d04072 0132d939503e5f17 [retrieved on 2016-10-18]

## Beschreibung

Die Erfindung betrifft einen Leistungshalbleiterschalter mit wenigstens zwei parallel zueinander geschalteten Leistungshalbleitersegmenten, die jeweils einen Kollektoranschluss sowie einen Emitteranschluss als Lastanschlüsse aufweisen, und mit wenigstens einem Steueranschluss zum Überführen des Leistungshalbleiterschalters von seiner Sperrstellung, in der ein Stromfluss zwischen den Lastanschlüssen aller Leistungshalbleitersegmente unterbrochen ist, in seine Durchlassstellung, in der ein Stromfluss zwischen den Lastanschlüssen aller Leistungshalbleitersegmente ermöglicht ist, oder umgekehrt.

Solche Leistungshalbleiterschalter werden beispielsweise in leistungselektrischen Anlagen der Energieübertragung und -verteilung eingesetzt. Bei der Hochspannungsgleichstromübertragung oder so genannten Flexible AC Transmission Systems (FACTS) spielen mehr und mehr selbstgeführte Umrichter eine Rolle. Selbstgeführte Umrichter weisen Leistungshalbleiter mit Abschaltfähigkeit wie beispielsweise IGBTs, GTOs, IGCTs oder dergleichen auf. Die ein- und abschaltbaren Leistungshalbleiter liegen im Falle von IGBTs als Leistungshalbleiterchips vor, die wiederum zu Leistungshalbleiterschaltern verbaut sind. Die Leistungshalbleiterschalter werden aufgrund der hohen Spannungen in der Regel in Reihenschaltungen eingesetzt. Der Ausfall eines einzelnen Leistungshalbleiters oder der dazugehörigen Elektronik darf aufgrund von Verfügbarkeitsanforderungen nicht zu einer Abschaltung der gesamten Anlage oder des Systems führen. Deshalb werden in den besagten Reihenschaltungen redundante Levels eingebaut. Bei einem solchen Level handelt es sich beispielsweise um einen einzelnen Leistungshalbleiterschalter mit zugehöriger Freilaufdiode, Ansteuer- und Überwachungselektronik und Schalter. Im Falle von Multi-Level-Umrichtern kann ein solches Level durch Submodule realisiert sein, die jeweils einen eigenen Energiespeicher und eine hierzu parallele Leistungshalbleiterschaltung aufweisen.

Entscheidend für die Erzielung einer Redundanz ist die Eigenschaft, dass nach Ausfall eines Levels ein niederohmiger Strompfad anstelle des defekten Levels zur Verfügung stehen muss. Nur Leistungshalbleiter mit spezieller Aufbautechnik besitzen in der Regel diese Eigenschaften, die im Englischen als "Conduct on Fail" bezeichnet wird. Druckkontaktierte Bauelemente, die im Englischen als "Press-pack" bezeichnet werden, weisen diese Fähigkeit innerhalb gewisser Stromgrenzen auf.

Nachteilig ist der hohe mechanische Aufwand zur Herstellung der druckkontaktierten Scheibenzellenhalbeiter, so dass diese Komponenten teuer sind. Entsprechend gering ist die Anzahl der Hersteller der Bauelemente. Druckkontaktierte IGBTs sind beispielsweise von der Firma Toshiba oder der Firma Westcode kommerziell erhältlich. Auch das Unternehmen ABB stellt druckkontaktierte IGBTs her.

Die in den Anlagen der Energieübertragung und -verteilung heute überwiegend eingesetzten IGBT-Bausteine haben die gemeinsame Eigenschaft, dass eine Reihe von kleinflächigen Chips parallel geschaltet ist, um die erforderliche Stromtragfähigkeit zu erreichen. Als industrieller Standard hat sich im Gegensatz zu druckkontaktierten IGBT-Bauelementen dabei die Modulbauform etabliert, bei der die Chips mit einer Seite auf ein Substrat gelötet werden und auf der anderen Seite mit Bonddrähten kontaktiert sind.

Da sich bei Ausfall eines Chips der gesamte Laststrom zunächst auf diesen ausgefallenen Chip konzentriert, werden die mit diesem ausgefallen Chip verbundenen Bonddrähte durch den Laststrom überlastet, so dass diese schmelzen können mit der Ausbildung eines Lichtbogens und der Explosion des gesamten Moduls im Gefolge. Die industrieüblichen IGBT-Module mit Lötbondtechnik besitzen daher nicht die inhärente Eigenschaft, bei ihrer Zerstörung eine niederohmige Verbindung auszubilden, so dass eine Überbrückung des fehlerhaften Bauteils bereitgestellt ist. Aus diesem Grunde sind bei einem Einsatz dieser Leistungshalbleiterschalter in Anlagen der Energieübertragung und -verteilung zusätzliche Maßnahmen erforderlich.

Bei einem so genannten modularen Multi-Level-Umrichter unter Verwendung industrieüblicher Leistungshalbleiterschalter mit Löt-Bond-Technik wird der niederohmige Strompfad zur Überbrückung eines fehlerhaften Submoduls mit Hilfe eines mechanischen Bypassschalters realisiert, wobei die Auslösung über eine Detektion des Überschreitens eines Spannungsniveaus oder eines Gradienten der Spannung des zugehörigen Submodulkondensators erfolgt. Nachteilig an dieser Lösung ist jedoch die relativ aufwändige Elektronik zur Versorgung und Erfassung zum Nachweis und zum schließlichen Auslösen des Bypassschalters. Werden in Umrichtern mit Zwei- oder Dreipunkttechnik oder mit einer Multileveltopologie statt eines einzelnen Leistungshalbleiterschalters mehrere Leistungshalbleiterschalter in Reihe geschaltet, ist eine derartige Erfassung zur Auslösung eines Bypasses oder Überbrückungsschalters an einem einzelnen Leistungshalbleiterschalter nicht möglich, da eine Zwischenkreisentladung wegen der restlichen fehlerfreien Leistungshalbleiterschalter der Reihenschaltung wunschgemäß nicht erfolgt. Die bisherige Messtechnik zur Überwachung und Überbrückung des Fehlers kann daher bei einer solchen Reihenschaltung nicht mehr eingesetzt werden. Aus diesem Grunde kommen bislang nur die oben beschriebenen konstenintensiven druckkontaktierten Bauelemente mit ihrer inhärenten Conduct on Fail-Eigenschaft zum Einsatz.

Aus dem Artikel "Non-invasive measurement of chip currents in IGBT modules" von Palmer et al (Power Electronics Specialists Conference, 1997. PESC '97 record., vol. 1, 22 June 1997, pages 166-171, ISBN: 978-0-7803-3840-1) ist ein IGBT-Moduls bekannt, bei dem mehrere IGBT-Chips parallelgeschaltet sind. An zwei dieser Chips ist an den Anodenanschlüssen jeweils ein Magnetfeldsensor angebracht, um die über diese Chips jeweils fließenden Ströme bei Abschalten des IGBT-Moduls zu messen.

Der Artikel "Online and offline isolated current monitoring of parallel switched high-voltage multi-chip IGBT modules" von Dalessandro et al (Power Electronics Specialists Conference, 2008. PESC 2008, 15 June 2008, pages 2600-2606, ISBN: 978-1-4244-1667-7) offenbart eine Strommessung innerhalb eines IGBT-Modules mittels einer Rogowskispule oder mittels eines HOKA-Sensors. Mittels der Rogowskispule werden Wechselströme gemessen, mittels des HOKA-Sensors sollen Ströme von Gleichstrom bis zu Frequenzen von 50 MHz gemessen werden können.

Aus der US 2006/0027917 A1 ist eine Anordnung mit zwei leistungselektronischen Bauelementen bekannt, die parallel zueinander geschaltet sind. Jedes der Bauelemente ist elektrisch mit einem eigenen Kontaktzonenabschnitt verbunden. Die beiden Kontaktzonenabschnitte sind mit einer Auswerteschaltung verbunden, welche ein Signal ausgibt, wenn der Spannungsunterschied zwischen den beiden Kontaktzonenabschnitten einen Schwellwert überschreitet.

Aus dem Artikel "An overview of integratable current sensor technologies" von CHUCHENG XIAO et al (conference record of the 2003 IEEE industry applications conference, 38TH. IAS annual meeting. Salt Lake City, Oct. 12 - 16, 2003; vol. 2, pages 1251-1258, ISBN: 978-0-7803-7883-4) ist bekannt, Stromwandler zur Messung von Strömen bei leistungselektronischen Modulen einzusetzen.

Das Patent US 2011/0103108 A1 offenbart eine Ventileinheit eines leistungselektronischen Konverters. Diese Ventileinheit weist zwei Gruppen mit jeweils zwei IGBTs auf. Ein Strompfad der ersten Gruppe und ein Strompfad der zweiten Gruppe verlaufen dabei in verschiedenen Richtungen. Wenn der Strom in den beiden Strompfaden gleich groß ist, dann tritt an einem Magnetflusssensor kein Magnetfluss auf.

Aus dem Dokument "Sense & Control; Current Sensing Using Linear Hall Sensors" der Infineon Technologies AG, Edition 2009-02-03 ist bekannt, zur Strommessung lineare Hall-Sensoren einzusetzen, die in einem Spalt eines ringförmigen Feldkonzentrators angeordnet sind.

Aufgabe der Erfindung ist es, einen Leistungshalbleiterschalter der eingangs genannten Art bereitzustellen, bei dem ein Fehler auch im Falle einer Reihe gleichartiger Leistungshalbleiterschalter einfach und zuverlässig erfasst werden kann.

Die Erfindung löst diese Aufgabe durch einen Leistungshalbleiterschalter nach dem Patentanspruch 1. Bei diesem Leistungshalbleiterschalter sind Mittel zur Erfassung einer unsymmetrischen Verteilung des Stromes auf die Lastanschlüsse vorgesehen.

Die Erfindung basiert auf der Idee, dass sich bei Normalbetrieb eines Leistungshalbleiterschalters der über die Leistungshalbleitersegmente fließende Gesamtstrom gleichmäßig auf dessen Lastanschlüsse aufteilt. Sind beispielsweise drei Leistungshalbleitersegmente mit jeweils einem Emitteranschluss und jeweils einem Kollektoranschluss vorgesehen, führt jeder dieser Lastanschlüsse in etwa den gleichen Strom. Im Fehlerfall, also bei Ausfall eines Chips, konzentriert sich der Stromfluss jedoch auf den defekten Chip und damit auf einen der Lastanschlüsse. Zur Detektion des Fehlers wird deshalb vorgeschlagen, mittels einer Messung des Stromes oder eines aus dem Strom abgeleiteten Größe eine Unsymmetrie der Stromverteilung auf die Lastanschlüsse zu detektieren. Dies kann beispielsweise durch Vergleich der Lastströme in den einzelnen Emitteranschlüssen und/oder aber durch Vergleich der einzelnen Stromflüsse der Kollektoranschlüsse erfolgen.

Erfindungsgemäß ist eine einfache Fehlererfassung auch bei in Reihe geschalteten Leistungshalbleiterschaltern möglich, so dass eine gezielte Überbrückung der fehlerhaften Leistungshalbleiterschalter der Reihenschaltung ermöglicht ist. Darüber hinaus ist im Rahmen der Erfindung eine Erfassungs- und Auslösevorrichtung bereitgestellt, die keine eigene Energieversorgung benötigt oder jedenfalls mit sehr geringen Leistungen auskommt, um die zur Fehlerüberwachung notwendigen Bauteile mit Energie zu versorgen. Die Erfindung beruht auch auf der Erkenntnis, dass bei Leistungshalbleiterschaltern, die beispielsweise am Markt erhältlich sind, Leistungshalbleitersegmente ausgebildet sind, die parallel zueinander geschaltet und weitestgehend unabhängige Strompfade ausbilden. Dabei verfügt jedes Leistungshalbleitersegment über seine eigenen zwei Lastanschlüsse, nämlich den Kollektoranschluss sowie den Emitteranschluss. Mit anderen Worten ist der Gesamtkollektoranschluss des Leistungshalbleiterschalters segmentweise aufgeteilt in die parallel zueinander geschalteten Kollektoranschlüsse der einzelnen Leistungshalbleitersegmente, von denen erfindungsgemäß wenigstens zwei vorhanden sein müssen, um die Möglichkeit zu haben, eine Unsymmetrie des Stromflusses auf die einzelnen Segmente feststellen zu können. Zweckmäßigerweise weisen die Mittel zur Erfassung einer unsymmetrischen Stromverteilung wenigstens einen Messsensor zur Erfassung eines Stromflusses über wenigstens zwei Lastanschlüsse oder zur Erfassung einer aus dem besagten Stromfluss abgeleiteten Größe auf. Beispielsweise ist der oder sind die Messsensoren ein Stromwandler, eine Rogowski-Spule und/oder ein Hallsensor.

Gemäß der Erfindung umfassen die Mittel zur Erfassung einer unsymmetrischen Stromverteilung ein weichmagnetisches Joch und wenigstens einen Messsensor, der zum Erfassen eines magnetischen Feldes in dem weichmagnetischen Joch eingerichtet ist. Gemäß dieser vorteilhaften Weiterentwicklung wird ein weichmagnetisches Joch eingesetzt, um eine von Stromflüssen abgeleitete Größe, in diesem Fall ein magnetisches Feld zu bündeln. Diese Bündelung verringert den messtechnischen Aufwand. Dabei umschließt das weichmagnetische Joch zweckmäßigerweise ein oder mehrere Paare von Lastanschlüssen in der Weise, dass bei einer symmetrischen Stromverteilung auf die von den weichmagnetischen Joch umschlossenen Lastanschlüssen, die sich im weichmagnetischen Joch einstellenden Magnetfelder zumindest in einem Teilbereich des magnetischen Joches gegenseitig auslöschen. Erst bei einer asymmetrischen oder mit anderen Worten unsymmetrischen Stromverteilung kommt es zu einem Ansteigen des Magnetfeldes im weichmagnetischen Joch und somit zu einer nachweisbaren Größe, die beispielsweise von einer einzigen Messspule eines Messsensors, die um einen Schenkel des weichmagnetischen Jochs gewickelt ist, erfasst werden kann. Da nicht mehr Messsensoren für jedes Leistungshalbleitersegment, sondern nur noch ein Messsensor benötigt wird, sind die Kosten verringert.
Zweckmäßigerweise umgibt das weichmagnetische Joch Lastanschlüsse paarweise. Das weichmagnetische Joch weist einen Verbindungssteg auf, so dass jeweils zwei Kollektor- oder Emitteranschlüsse von den gleichen Schenkeln des weichmagnetischen Joches umschlossen sind.

Zweckmäßigerweise weist der Leistungshalbleiterschalter Leistungshalbleiterchips auf, die in einem Gehäuse angeordnet sind. Die Lastanschlüsse und der oder die Steueranschlüsse sind aus dem Gehäuse herausgeführt, so dass ein Anschluss des Leistungshalbleiterschalters ermöglicht ist. Zweckmäßigerweise sind die Leistungshalbleiterchips beispielsweise IGBT-Chips über Bonddrähte miteinander verbunden. Gemäß einer bevorzugten Ausgestaltung der Erfindung weisen die Leistungshalbleiterchips steuerbare Leistungshalbleiterchips und Diodenchips auf, wobei die Leistungshalbleiterchips und die Diodenchips in voneinander unabhängigen Leistungshalbleitersegmenten unterteilt sind.
Zweckmäßigerweise ist eine gerade Anzahl von Leistungshalbleitersegmenten vorgesehen. Bevorzugt sind vier unabhängige Leistungshalbleitersegmente ausgebildet.
Weitere zweckmäßige Ausgestaltungen und Vorteile der Erfindung sind Gegenstand der nachfolgenden Beschreibung von Ausführungsbeispiele der Erfindung unter Bezug auf die Figuren der Zeichnung, wobei gleiche Bezugszeichen auf gleichwirkende Bauteile verweisen und wobei
Figur 1 einen vorbekannten Leistungshalbleiterschalter in Modulbauweise mit Löt-Bond-Technik,
Figur 2 einen Leistungshalbleiterchip des Leistungshalbleiterschalters gemäß Figur 1,
Figur 3 einen vorbekannten Scheibenzellen IGBT,
Figur 4 ein Beispiel eines Leistungshalbleiterschalters der nicht unter den Schutzumfang fällt,
Figur 5 ein Ausführungsbeispiel des erfindungsgemäßen Leistungshalbleiterschalters und
Figur 6 ein weiteres Beispiel eines Leistungshalbleiterschalters, der nicht unter den Schutzumfang fällt,
zeigen.

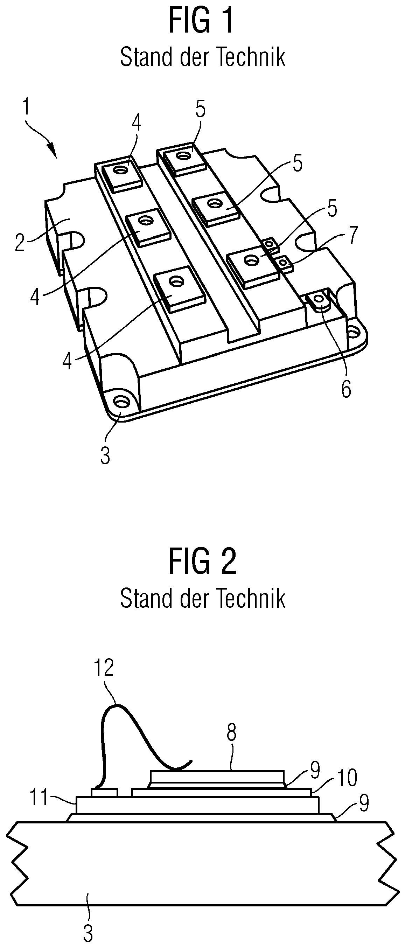

Figur 1 zeigt eine perspektivische Ansicht eines Leistungshalbleiterschalters 1 gemäß dem Stand der Technik, der auch als Leistungshalbleitermodul bezeichnet wird. Es ist erkennbar, dass der Leistungshalbleiterschalter 1 ein Gehäuse 2 aufweist, das aus einem nichtleitenden Material besteht und mit einem metallischen Basisträger 3 verbunden ist. An seiner Oberseite weist der Leistungshalbleiterschalter 1 drei Kollektoranschlüsse 4 sowie drei Emitteranschlüsse 5 auf. Zur Ansteuerung dient ein so genannter Gate- oder Steueranschluss 6. Ferner ist ein Hilfsemitteranschluss 7 erkennbar, mit welchem am Gateanschluss 6 das zweckmäßige elektrische Potenzial aufgeprägt werden kann.

Innerhalb des Gehäuses 2 sind Leistungshalbleiterchips beispielsweise IGBT-(Insulated-Gate Bipolar Transistor)-Chips angeordnet, die ebenfalls Stand der Technik und in Figur 2 verdeutlicht sind.

Die Figur 2 zeigt in einer Seitenansicht schematisch einen IGBT-Chip 8 des Leistungshalbleiterschalters 1 gemäß Figur 1, der über eine Lötverbindung 9 mit einer leitenden Kupferschicht 10 verbunden ist, die auf einem nichtleitenden Substrat 11, beispielsweise aus einer zweckmäßigen Keramik, aufgebracht ist. Das Substrat 11 ist mechanisch über eine weitere Lötverbindung 9 mit dem Basisträger 3 verbunden. Zur elektrischen Verbindung mit weiteren Leistungshalbleiterchips oder Diodenchips dienen Bonddrähte 12, von denen in Figur 2 aus Gründen Übersichtlichkeit lediglich einer gezeigt ist. Es ist ferner erkennbar, dass die Kupferschicht 10 Leiterbahnen ausbildet, mit denen eine zweckmäßige Verschaltung der IGBT-Chips 8 u. a. mittels der Bonddrähte 12 ermöglicht ist.

Der in Figur 1 gezeigte Leistungshalbleiterschalter 1 weist insgesamt 24 IGBT-Chips gemäß Figur 2 sowie zwölf gegensinnige Diodenchips auf, die alle in dem Gehäuse 2 untergebracht sind. Alternativ hierzu können auch 18 IGBT-Chips und 18 Diodenchips verbaut sein. Als weitere Alternative können 36 rückwärtsleitende IGBT-Chips in dem Gehäuse untergebracht sein, wobei eine Diode und der IGBT in einem Chip integriert sind. Diese Leistungshalbleiterchips sind in drei voneinander weitgehend unabhängig parallel geschalteten Leistungshalbleitersegmenten angeordnet, so dass ein Leistungshalbleitersegment über jeweils acht IGBT-Chips und vier Dioden-Chips verfügt. Die Lastanschlüsse dieser drei Leistungshalbleitersegmente, also drei Kollektoranschlüsse 4 sowie drei Emitteranschlüsse 5 sind einzeln aus dem Gehäuse herausgeführt und somit einzeln kontaktierbar. Dabei können die Lastanschlüsse an der gleichen Gehäuseseite oder an voneinander abgewandten Gehäuseseiten angeordnet sein. Während des Normalbetriebs teilt sich der gesamte über den Leistungshalbleiterschalter 1 fließende Strom in etwa gleich auf die drei Leistungshalbleitersegmente mit ihrem jeweiligen Kollektor- 4 und Emitteranschluss 5 auf. Mit anderen Worten führt der Zuleiter eines jeden Kollektoranschlusses 4 bzw. der Zuleiter eines jeden Emitteranschlusses 5 in etwa den gleichen Strom.

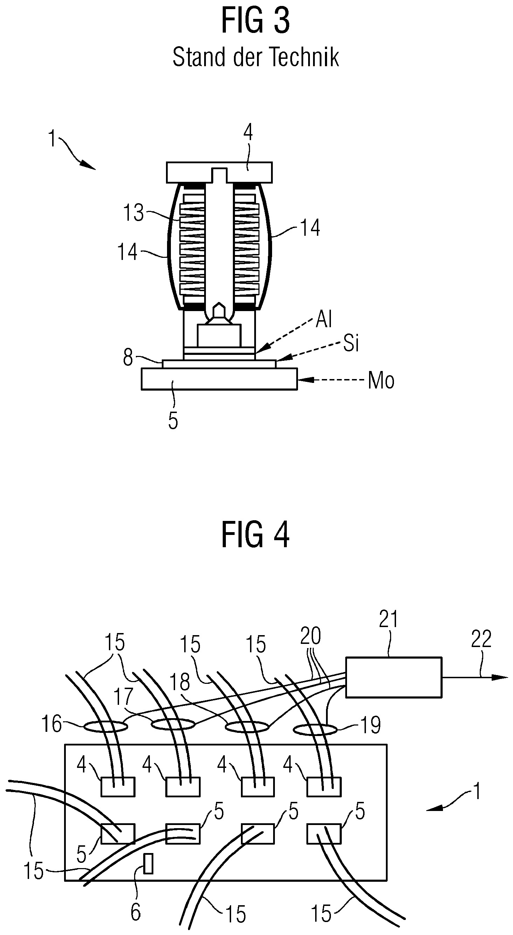

Figur 3 zeigt einen IGBT-Chip 8 eines vorbekannten druckkontaktierten Leistungshalbleiterschalters 1, der die eingangs erwähnte "Conduct on Fail"-Eigenschaft aufweist. Der in Figur 3 gezeigte Leistungshalbleiterschalter 1 ist ebenfalls in Segmente unterteilt, wobei jedes Segment über einen Kollektoranschluss 4 sowie über einen Emitteranschluss 5 verfügt. Im Gegensatz zur Modulbauweise weist ein "Press-pack" gemäß Figur 3 auf der Emitterseite jedoch keine Bonddrähte zur Verbindung der IGBT-Chips 8 auf. Auf dem Emitter 5 sind die Leistungshalbleiterchips 8 über ein Federelement 13 mit Druck beaufschlagt, so dass das Leistungshalbleiterchip 8 flächig gegen den Emitteranschluss 5 gepresst wird. Die elektrisch leitende Verbindung mit dem Kollektoranschluss 4 wird über einen flexiblen Bandleiter 14 bereitgestellt, mit dem das Federelement 13 elektrisch überbrückt ist. Im Fehlerfall wird der Leistungshalbleiterchip 8 leitend, so dass die gewünschte "Conduct on Fail"-Eigenschaft bereitgestellt ist. Bei einer Reihenschaltung von Leistungshalbleiterschaltern 1 gemäß Figur 3 führt die Auswahl eines Leistungshalbleiterschalters 1 nicht dazu, dass die gesamte Reihenschaltung ihren Betrieb nicht mehr fortsetzen kann. Vielmehr übernehmen die mit dem fehlerhaften Leistungshalbleiterschalter 1 in Reihe geschalteten Leistungshalbleiterschalter 1 die Funktion, die der fehlerhafte Leistungshalbleiterschalter bisher ausgefüllt hatte. Bei turnusmäßig stattfindenden Wartungsarbeiten kann der fehlerhafte Leistungshalbeiterschalter 1 schließlich ausgetauscht werden.

Figur 4 zeigt ein Beispiel das nicht in den Schutzumfang der Erfindung fällt. Dort ist schematisch ein Leistungshalbleiterschalter 1 gezeigt, der vier Leistungshalbleitersegmente aufweist, so dass deren vier Kollektoranschlüsse 4 bzw. deren vier Emitteranschlüsse 5 aus dem Gehäuse 2 zur gleichen Gehäuseseite nach außen geführt sind. Ferner ist ein Steuerungsanschluss 6 erkennbar, mit dem die Leistungshalbleitersegmente, die einander parallel geschaltet sind, von einer Durchlassstellung in der ein Stromfluss zwischen dem jeweiligen Kollektor- und Emitteranschluss 4, 5 ermöglicht ist, in die Sperrstellung oder umgekehrt überführbar sind, in der ein Stromfluss zwischen Emitter- und Kollektoranschluss 4, 5 unterbrochen ist.
In Figur 4 ist ferner erkennbar, dass jeder der Kollektor- oder Emitteranschlüsse 4, 5 mit einer Zuleitung 15 versehen ist. Die Zuleitungen 15 sind in unmittelbarer physikalischer Nähe des jeweiligen Emitteranschlusses 4 jeweils mit einem nur schematisch angedeuteten Stromwandler 16, 17, 18 und 19 ausgerüstet, deren Messsignale über Signalleitungen 20 durch eine schematisch angedeutete Verschaltung 21 einander aufaddiert werden. Dabei weisen die Stromwandler 16 und 17 eine Messspule mit gleicher Wicklungsrichtung auf. Die Stromwandler 18 und 19 weisen jedoch bezüglich der Stromwandler 16 und 17 eine entgegengesetzte Wicklungsrichtung auf. Bei einem fehlerfreien Betrieb ist somit das Ausgangssignal 22 der miteinander verschalteten Stromwandler 16, 17, 1 und 19 im Wesentlichen gleich Null. Im Fehlerfall konzentriert sich jedoch der Stromfluss auf das fehlerhafte Leistungshalbleitersegment mit einem Anstieg des Ausgangssignals 22 im Gefolge. Das Ausgangssignal 22 kann nun direkt zur Auslösung eines Überbrückungsschalters beispielsweise eines pyrotechnisch ausgelösten Bypassschalters oder eines sonstigen mechanischen Schalters oder aber auch eines elektrischen Schalters, wie eines Thyristors, eingesetzt werden. In dem in Figur 4 gezeigten Ausführungsbeispiel umfassen die Mittel zur Erfassung einer unsymmetrischen Verteilung des Stromes auf die Lastanschlüsse 4, 5 die Stromwandler 16, 17, 18, 19, die Messsignalleitung 20 und die Verschaltung 21.

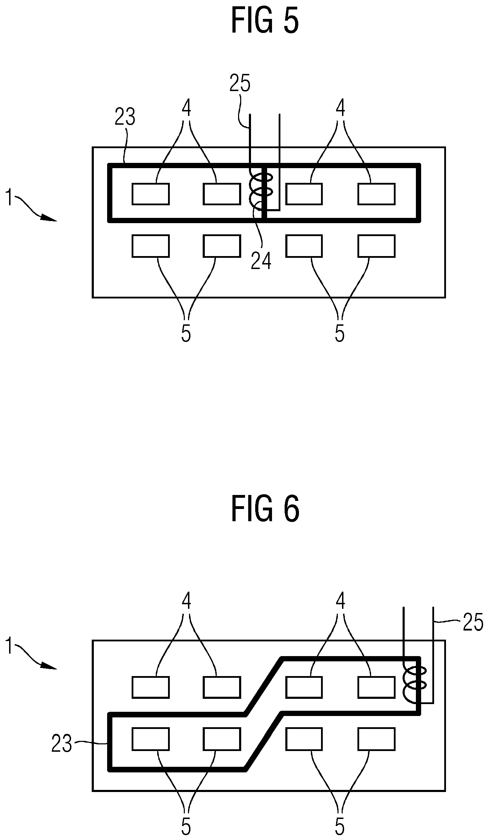

Figur 5 zeigt ein Ausführungsbeispiel der Erfindung, bei dem die Mittel zur Erfassung einer unsymmetrischen Verteilung des Stromes auf die Lastanschlüsse ein weichenmagnetisches Joch 23 aufweisen, das die Kollektoranschlüsse 4 ringförmig umschließt. Zwischen den beiden Längsseiten des weichenmagnetischen Jochs 23 ist ein Verbindungssteg 24 ausgebildet, der wiederum von einer Messspule 25 eines Messsensors umwickelt ist. Auf diese Weise sind zwei Paare von Kollektoranschlüssen 4 gleichförmig von den Schenkeln des weichenmagnetischen Joches 23 umgeben. Bei einer symmetrischen Stromverteilung auf die Kollektoranschlüsse verursachen die Ströme über jeden der Kollektoranschlüsse 4 die Ausbildung magnetischer Felder, die sich im Verbindungssteg 24 als Teilbereich des weichmagnetischen Jochs 23 im Wesentlichen gegenseitig auslöschen. Das Signal der Messspule 25, die in dem besagten Teilbereich angeordnet ist, ist im fehlerfreien Betrieb somit quasi gleich Null. Im Fehlerfall kommt es jedoch zu einer Unsymmetrie und somit zu einem starken Anstieg des Magnetfeldes im Verbindungssteg 24 des Joches 23, welches über die Spule 25 leicht nachgewiesen werden kann.

Figur 6 zeigt ein nicht in den Schutzumfang fallendes Beispiel gemäß Figur 5 in einer abweichenden Ausgestaltung, wobei das weichenmagnetische Joch 23 zwei Kollektoranschlüsse sowie zwei Emitteranschlüsse 5 umschließt, deren Magnetfelder sich bei Normalbetrieb in dem gesamten weichenmagnetischen Joch 23 gegenseitig auslöschen. Auch hier bewirkt ein Fehler eines Leistungshalbleitersegmentes eine unsymmetrische Stromverteilung und somit ein nachweisbares magnetisches Feld im Joch 23, so dass die Messspule 25 ein Ausgangssignal erzeugt.

## Patentansprüche

1. Leistungshalbleiterschalter (1) mit wenigstens zwei parallel zueinander geschalteten Leistungshalbleitersegmenten, die jeweils einen Kollektoranschluss (4) sowie einen Emitteranschluss (5) als Lastanschlüsse (4, 5) aufweisen, mit wenigstens einem Steueranschluss zum Überführen des Leistungshalbleiterschalters von seiner Sperrstellung, in der ein Stromfluss zwischen den Lastanschlüssen aller Leistungshalbleitersegmente unterbrochen ist, in seine Durchlassstellung, in der ein Stromfluss zwischen den Lastanschlüssen (4, 5) aller Leistungshalbleitersegmente ermöglicht ist, oder umgekehrt, und mit Mitteln (16, 17, 18, 19, 20, 21) zur Erfassung einer unsymmetrischen Verteilung des Stromes auf die Lastanschlüsse (4, 5), wobei
- die Mittel (16, 17, 18, 19, 20, 21) zur Erfassung einer unsymmetrischen Stromverteilung ein weichmagnetisches Joch (23, 24) aufweisen, welches eine gerade Anzahl von entweder nur Kollektor- oder nur Emitteranschlüssen (4, 5) ringförmig umschließt und welches zwei Längsseiten und einen Verbindungssteg (24) aufweist, wobei der Verbindungssteg (24) zwischen den beiden Längsseiten ausgebildet ist, so dass das weichmagnetische Joch besagte Kollektor- oder Emitteranschlüsse paarweise gleichförmig umgibt, und wenigstens ein Messsensor (25) vorgesehen ist, der zum Erfassen eines magnetischen Feldes in dem weichmagnetischen Joch (23, 24) eingerichtet ist, und
- die von dem Strom über die Lastanschlüsse (4, 5) erzeugten Magnetfelder sich zumindest in einem Teilbereich des weichmagnetischen Jochs (23, 24), an dem der Messsensor angeordnet ist, bei einer symmetrischen Stromverteilung gegenseitig auslöschen, wobei der Teilbereich der Verbindungssteg (24) ist.

2. Leistungshalbleiterschalter (1) nach Anspruch 1,
**dadurch gekennzeichnet, dass** der Messsensor (25) ein Stromwandler, eine Rogowski-Spule und/oder ein Hallsensor ist.

3. Leistungshalbleiterschalter (1) nach einem der vorhergehenden Ansprüche,
**dadurch gekennzeichnet, dass**
ein Gehäuse (2) vorgesehen ist, in dem Leistungshalbleiterchips (8) angeordnet sind.

4. Leistungshalbleiterschalter (1) nach Anspruch 3,
**dadurch gekennzeichnet, dass**
die Leistungshalbleiterchips (8) über Bonddrähte (15) miteinander verbunden sind.

5. Leistungshalbleiterschalter (1) nach einem der Ansprüche 3 oder 4,
**dadurch gekennzeichnet, dass**
die Leistungshalbleiterchips (8) aus steuerbaren Leistungshalbleiterchips und Diodenchips bestehen, wobei die Leistungshalbleiterchips und Diodenchips in voneinander unabhängige Leistungshalbleitersegmente unterteilt sind, wobei jedes Leistungshalbleitersegment einen Kollektoranschluss (4) und einen Emitteranschluss (5) sowie einen Steuerungsanschluss (6) aufweist.

6. Leistungshalbleiterschalter (1) nach Anspruch 4,
**dadurch gekennzeichnet, dass**
2n unabhängige Leistungshalbleitersegmente ausgebildet sind wobei n eine ganze positive Zahl ist.

## Claims

1. Power semiconductor switch (1) comprising at least two power semiconductor segments connected in parallel with one another and each having a collector terminal (4) and an emitter terminal (5) as load terminals (4, 5), comprising at least one control terminal for transferring the power semiconductor switch from its off-state position, in which a flow of current between the load terminals of all the power semiconductor segments is interrupted, to its on-state position, in which a flow of current between the load terminals (4, 5) of all the power semiconductor segments is made possible, or vice versa, and comprising means (16, 17, 18, 19, 20, 21) for detecting an asymmetrical distribution of the current over the load terminals (4, 5), wherein
- the means (16, 17, 18, 19, 20, 21) for detecting an asymmetrical current distribution comprise a soft-magnetic yoke (23, 24), which encloses an even number of either just collector or just emitter terminals (4, 5) in an annular manner and which has two longitudinal sides and a connecting web (24), wherein the connecting web (24) is formed between the two longitudinal sides so that the soft-magnetic yoke uniformly surrounds said collector or emitter terminals in pairs, and at least one measurement sensor (25) is provided, which is configured to detect a magnetic field in the soft-magnetic yoke (23, 24), and
- in the case of a symmetrical current distribution the magnetic fields generated by the current over the load terminals (4, 5) cancel each other out at least in a subregion of the soft-magnetic yoke (23, 24) at which the measurement sensor is arranged, wherein the subregion is the connecting web (24) .

2. Power semiconductor switch (1) according to Claim 1, **characterized in that** the measurement sensor (25) is a current converter, a Rogowski coil and/or a Hall sensor.

3. Power semiconductor switch (1) according to either of the preceding claims, **characterized in that** a housing (2) is provided, in which power semiconductor chips (8) are arranged.

4. Power semiconductor switch (1) according to Claim 3, **characterized in that** the power semiconductor chips (8) are connected to one another by means of bonding wires (15).

5. Power semiconductor switch (1) according to either of Claims 3 and 4, **characterized in that** the power semiconductor chips (8) consist of controllable power semiconductor chips and diode chips, wherein the power semiconductor chips and diode chips are divided into power semiconductor segments that are independent of one another, wherein each power semiconductor segment has a collector terminal (4) and an emitter terminal (5) as well as a control terminal (6).

6. Power semiconductor switch (1) according to Claim 4, **characterized in that** 2n independent power semiconductor segments are formed, wherein n is a whole positive integer.

## Revendications

1. Commutateur (1) à semi-conducteur de puissance, ayant au moins deux segments à semi-conducteur de puissance, qui sont montés en parallèle l'un avec l'autre, qui ont chacun une borne (4) de collecteur, ainsi qu'une borne (5) d'émetteur, comme bornes (4, 5) de charge, comprenant au moins une borne de commande pour faire passer le commutateur à semi-conducteur de puissance de sa position bloquée, dans laquelle un flux de courant entre les bornes de charge de tous les segments à semi-conducteur de puissance est interrompu à sa position passante, dans laquelle un flux de courant entre les bornes (4, 5) de charge de tous les segments à semi-conducteur de puissance est rendu possible ou inversement, et comprenant des moyens (16, 17, 18, 19, 20, 21) de détection d'une répartition dissymétrique du courant sur les bornes (4, 5) de charge, dans lequel
- les moyens (16, 17, 18, 19, 20, 21) de détection d'une répartition dissymétrique du courant ont une culasse (23, 24) à magnétisme doux, qui entoure annulairement un nombre pair, soit seulement de bornes (4) de collecteur, soit seulement de bornes (5) d'émetteur, et qui a deux grands côtés et une entretoise (24) de liaison, l'entretoise (24) de liaison étant constituée entre les deux grands côtés, de manière à ce que la culasse à magnétisme doux entoure, uniformément par paire, lesdites bornes de collecteur ou d'émetteur, et il est prévu au moins un capteur (25) de mesure, conçu pour détecter un champ magnétique dans la culasse (23, 24) à magnétisme doux et
- les champs magnétiques produits par le courant sur les bornes (4, 5) de charge s'effacent mutuellement, s'il y a une répartition symétrique du courant, au moins dans une région partielle de la culasse (23, 24) à magnétisme doux, sur laquelle le capteur de mesure est monté, la région partielle étant l'entretoise (24) de liaison.

2. Commutateur (1) à semi-conducteur de puissance suivant la revendication 1,
**caractérisé en ce que**
le capteur (25) de mesure est un transformateur de courant, une bobine de Rogowski et/ou un capteur de Hall.

3. Commutateur (1) à semi-conducteur de puissance suivant l'une des revendications précédentes,
**caractérisé en ce qu'**
il est prévu un boîtier (2), dans lequel sont disposés des puces (8) à semi-conducteur de puissance.

4. Commutateur (1) à semi-conducteur de puissance suivant la revendication 3,
**caractérisé en ce que**
les puces (8) à semi-conducteur de puissance sont reliées entre elles par des fils (15) de liaison.

5. Commutateur (1) à semi-conducteur de puissance suivant l'une des revendications 3 ou 4,
**caractérisé en ce que**
les puces (8) à semi-conducteur de puissance sont constituées de puces à semi-conducteur de puissance et de puces à diode pouvant être commandées, les puces à semi-conducteur de puissance et les puces à diode étant subdivisées en des segments à semi-conducteur de puissance indépendants les uns des autres, chaque segment à semi-conducteur de puissance ayant une borne (4) de collecteur et une borne (5) d'émetteur, ainsi qu'une borne (6) de commande.

6. Commutateur (1) à semi-conducteur de puissance suivant la revendication 4,
**caractérisé en ce qu'**
il est constitué 2n segments à semi-conducteur de puissance indépendants, n étant un nombre entier positif.
